# EUROPEAN PATENT APPLICATION

(11) **EP 1 953 573 A1**
(43) Date of publication of application: **06.08.2008**
(21) Application number: 07002428.6
(22) Date of filing: 05.02.2007
(51) Int. Cl.: G02B 3/12, G02B 5/06, H01L 31/0232

(54) **A liquid inserted lens and solar panel focusing system**

(71) Applicant: Paul & Charlene Investment Inc., Tao-Yuan (TW)
(72) Inventor: Pei, Paul, Tao-Yuan (TW)
(74) Representative: TER MEER - STEINMEISTER & PARTNER GbR

(57) **Abstract**

The present invention discloses a liquid inserted lens and solar panel focus system. Liquid such as water is inserted into a transparent solid casing with the shape of a convex lens to form a convex lens. A solar panel is placed between the convex lens and the focus point of the convex lens, such that the sunlight can be focus on the solar cells to increase light intensity and produce more electric energy. This structure reduces the weight of the lens and its cost, and can be used in the focusing of solar panel system or other shape of lens for different application such as a photo-telescope, optical microscope or triangular prism to reduce the weight of the lens.

## Description

### BACKGROUND OF THE INVENTION

### 1. Field of the invention

The present invention relates to a liquid inserted lens. In particular, to a liquid inserted lens and solar panel focus system.

### 2. Description of the Related Art

Solar panel is an important power source in the future. In order to increase the efficiency of the solar cell, the structure and material used are improving continuously. The efficiency of the solar cell has reached above 20% or more. Focusing and heat dissipation are the targets of development for increasing the output current of the solar cell.

The technology used in R.O.C.(Taiwan) PAT. NO. 00544945 to Tanaka et al. "A solar energy transformer by using focus light through liquid" is a solar cell to be inserted into a liquid, Thus wetting the solar cell and improving the focusing of light by refraction and reflection in the liquid to increase the output current.

The technology used in U.S. PAT. NO. 4081289 to Campbell, 111 et al. is a system for extracting energy from the sun's rays including a bank of solar energy cells is immersed in a bath of liquid formed to serve as a lens, concentrating the sun rays on the cells, and transmitting heat away from the cells.

The technology used in U.S. PAT. NO. 4172740 to Campbell, 111 et al. is also immerses the solar cells in a bath of liquid formed to serve as a lens, but additionally includes a method for preheating the interior thereof. The converting unit is preferably equipped with light gathering and focusing means thereby providing coherent optically output.

Kirpich et al. in U.S. PAT. NO. 4491681, teaches a separate structures for electrical insulation and thermal conduction are established within a liquid cooled, linear focus solar cell receiver for use with parabolic or Fresnel optical concentrators. The receiver includes a V-shaped aluminum extrusion having a pair of outer faces each formed with a channel receiving a string of solar cells in thermal contact with the extrusion.

Olah et al. in U.S. PAT. NO.6399874, "Solar energy module and fresnel lens for use in same" teaches a solar concentrator having a housing that supports at least one photovoltaic cell therein, a primary optical concentrator is provided in the form of a Fresnel lens. The Fresnel lens has a central facet and a plurality of adjacent facets of varying widths, the width of each successive adjacent facet decreasing in the direction away from the central facet.

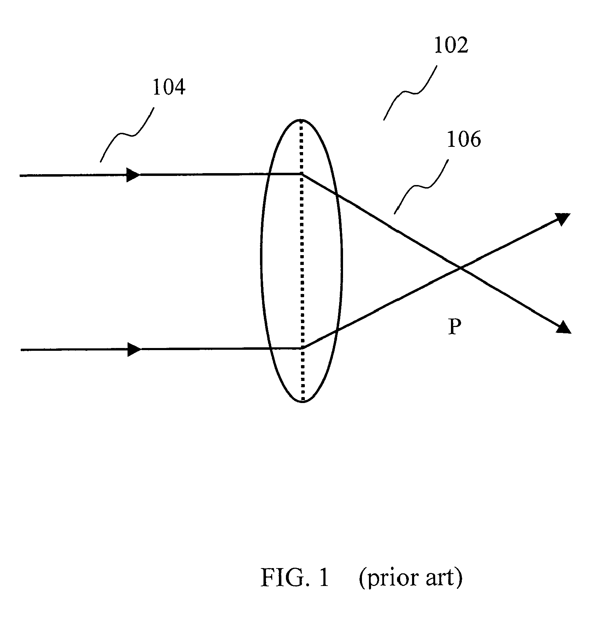

The prior arts make use of glass to focus the light. As shown in FIG.1. FIG.1 is a schematic diagram of a glass convex lens. When the glass convex lens 102 is focusing, the parallel sun light 104 is concentrated by the glass convex lens 102 to form concentrate light 106, the focus point is P. The drawbacks of the glass convex lens 102 are its heavy mass and the higher cost of glass material. Although immerses the solar cells in a bath of liquid have the effect of heat transfer and light focusing, the focusing ability is not enough.

There is a need to provide a lens to increase the focusing effect, cost down by using less glass and decrease the weight of the lens such that it is easy to install. The present invention thus provides a solar panel focus system to satisfy the focusing necessary.

### OBJECTS OF THE INVENTION

It is therefore an object of the invention to provide a structure of liquid inserted lens. By inserting liquid inside a hollow transparent solid housing, such as water, to form a lens to cost down by using less glass and decrease the weight of the lens such that it is easy to install.

It is another object of the invention to provide a solar panel focus system. A solar panel is placed between a liquid inserted convex lens and the focus point thereof, to transform the concentrated sun light into electric energy.

### DISCLOSURE OF THE INVENTION

A first aspect of the present invention teaches a structure of liquid inserted lens, including a hollow transparent solid housing, with the shape of a lens for inserting liquid inside thereof to decrease the weight of the lens. The hollow transparent solid housing is glass, transparent plastic, quartz or acrylic fiber. The thickness of the hollow transparent solid housing is between 0.3 mm to 8 mm, to support the gravity force and violence damage. The lens is a convex lens, concave lens or a triangular prism. A liquid is inserted inside the hollow transparent solid housing to form a lens. The liquid is water, ethanol, benzene, ceder oil or carbon disulfide.

Another preferred embodiment of the present invention teaches a solar panel focus system, including a liquid inserted convex lens, concentrating the sun light on a solar panel; a solar panel, constituted by solar cell arrays, is placing between said liquid inserted convex lens and the focus point of said liquid inserted convex lens to transform the concentrated sun light into electric energy.

### BRIEF DESCRIPTION OF THE DRAWINGS

The foregoing and other advantages of the invention will be more fully understood with reference to the description of the best embodiment and the drawing wherein:
FIG. 1 is a schematic diagram of a glass convex lens of the prior art.
FIG. 2 illustrates the cross sectional view of the structure of a liquid inserted lens in according to one embodiment of the present invention.
FIG. 3 is a schematic diagram of a liquid inserted convex lens in according to another embodiment of the present invention.
FIG. 4 is a schematic diagram of a solar panel focus system in according to another embodiment of the present invention.

### DESCRIPTION OF THE PREFERRED EMBODIMENTS

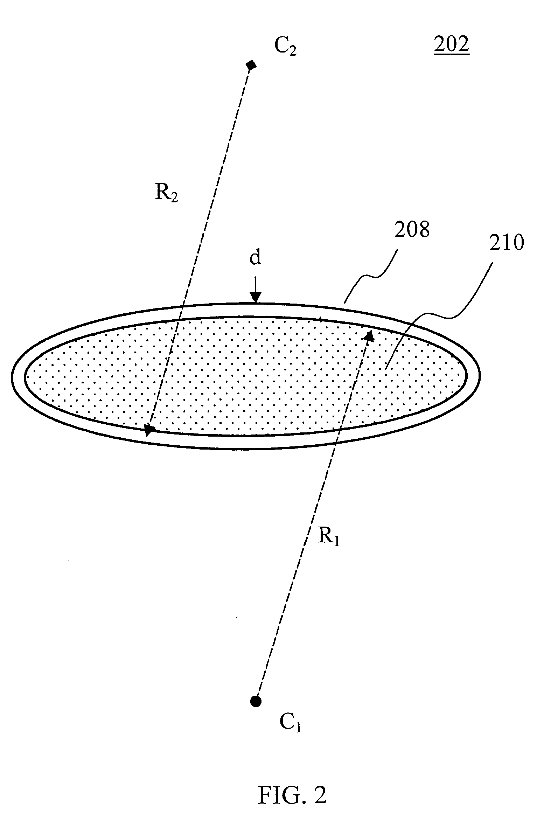

Refer to FIG. 2. FIG. 2 illustrates the cross sectional view of the structure of a liquid inserted lens in according to one embodiment of the present invention. A liquid inserted lens 202 has a hollow transparent solid housing 208, with the shape of a lens for inserting liquid inside. In this embodiment, the solid housing is a convex lens, the radius of curvature of the upper surface R₁, with C₁ as the center of curvature; the radius of curvature of the lower surface R₂, with C₂ as the center of curvature. The lens can have the shape for other performance, such as a concave lens or a triangular prism. The material of the hollow transparent solid housing 208 is glass, transparent plastic, quartz or acrylic fiber for decreasing the weight of the lens. The thickness d of the hollow transparent solid housing 208 is between 0.3 mm to 8 mm, which can support the gravity force and violence damage. A liquid 210 is inserted into the hollow transparent solid housing to form a lens. The inserted liquid is liquid is water, ethanol, benzene, ceder oil or carbon disulfide. The index of refraction of optical glass is 1.51201 and the index of refraction of water is 1.344661, the difference is not so much and can be compensated by adjusting the radius of curvature. The other liquid used is shown in Table 1:

**Table 1**

| Optical Glass | Index of Refraction n |
|---|---|
| Borocrown BK1 | 1.51201 |
| Dense crown SK1 | 1.61282 |
| Quartzglass | 1.4601 |
| Flint glass | 1.61681 |

| Liquid | |
|---|---|
| Water | 1.344661 |
| Ethanol | 1.365 |
| Benzene | 1.50545 |
| ceder oil | 1.5180 |
| carbon disulfide | 1.635 |

From Table 1, The inserted liquid with index of refraction close to optical glass is benzene, ceder oil or carbon disulfide, but the cost is too height, and has environment protection problem, thus it is prefer to use water.

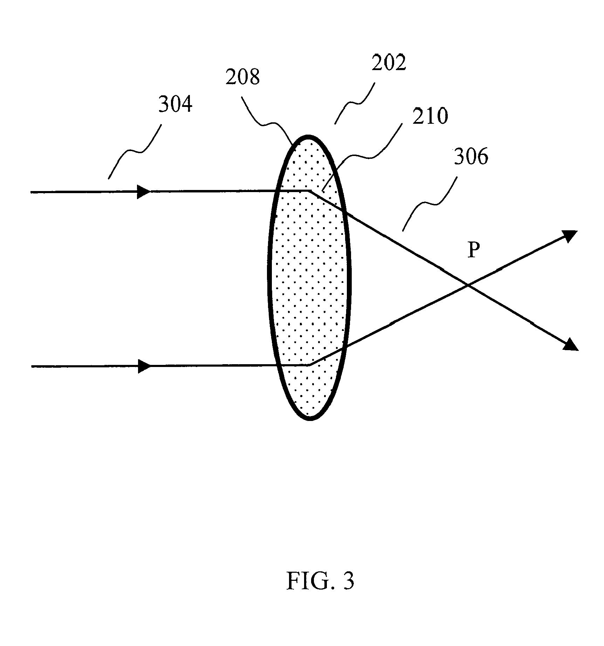

Refer to FIG. 3. FIG. 3 is a schematic diagram of a liquid inserted convex lens in according to another embodiment of the present invention. A convex lens 202 has a hollow transparent solid housing 208 and inserted with liquid 210, the parallel sun light 304 is concentrated by the liquid inserted convex lens 202 to form concentrate light 306, the focus point is P.

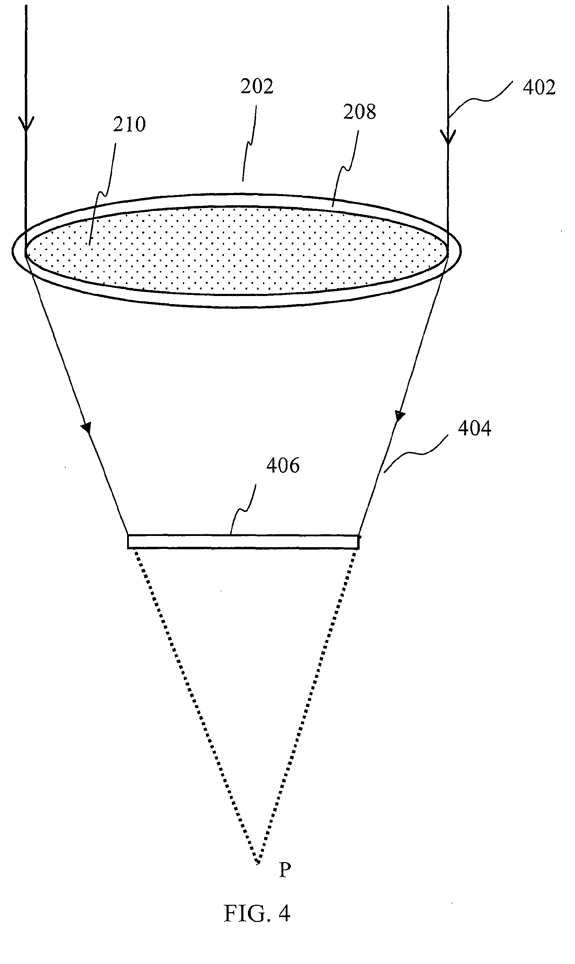

Refer to FIG. 4. FIG. 4 is a schematic diagram of a solar panel focus system in according to another embodiment of the present invention. Right under the convex lens 202 with a hollow transparent solid housing 208 and inserted with liquid 210, a solar panel 406 is placed between the convex lens 202 and the focus point of the convex lens. The position of the solar panel is selected such that after the sun light 402 go through the convex lens 202 and form a concentrate light 404, the solar panel can accept all of the concentrate light 404. For a small solar panel 406, the distance from the convex lens 202 is larger and is closer to the focus point P. For example, the surface area ratio of the convex lens/ the solar panel is 2:1, the solar panel should be positioned at the middle between the convex lens 202 and the focus point P of the convex lens, as shown in FIG. 4.

Although specific embodiments of the invention have been disclosed, it will be understood by those having skill in the art that minor changes can be made to the form and details of the specific embodiments disclosed herein, without departing from the scope of the invention. The embodiments presented above are for purposes of example only and are not to be taken to limit the scope of the appended claims.

Again, the inventive structure reduces the weight of the lens and its cost, and can be used in the focusing of solar panel system so as to increase light intensity on the solar cells and produce more electric energy, or other shape of lens for different application such as a photo-telescope, optical microscope or triangular prism to reduce the weight of the lens.

## Claims

1. A structure of liquid inserted lens, comprising:
a hollow transparent solid housing, with the shape of a lens for inserting liquid inside thereof to decrease the weight of the lens;
a liquid, inserting inside said hollow transparent solid housing.

2. A structure as recited in claim 1, the material of said hollow transparent solid housing is glass.

3. A structure as recited in claim 1, the material of said hollow transparent solid housing is transparent plastic.

4. A structure as recited in claim 1, the material of said hollow transparent solid housing is quartz.

5. A structure as recited in claim 1, the material of said hollow transparent solid housing is acrylic fiber.

6. A structure as recited in claim 1, wherein the thickness of said hollow transparent solid housing is between 0.3 mm to 8 mm.

7. A structure as recited in claim 1, wherein said lens is a convex lens.

8. A structure as recited in claim 1, wherein said lens is a concave lens.

9. A structure as recited in claim 1, wherein said lens is a triangular prism.

10. A structure as recited in claim 1, wherein said liquid is water.

11. A structure as recited in claim 1, wherein said liquid is ethanol.

12. A structure as recited in claim 1, wherein said liquid is benzene.

13. A structure as recited in claim 1, wherein said liquid is ceder oil.

14. A structure as recited in claim 1, wherein said liquid is carbon disulfide.

15. A solar panel focus system, comprising:
a liquid inserted convex lens, concentrating the sun light on a solar panel;
a solar panel, constituted by solar cell arrays, is placing between said liquid inserted convex lens and the focus point of said liquid inserted convex lens to transform the concentrated sun light into electric energy.
